# EUROPÄISCHE PATENTSCHRIFT

(11) **EP 0 945 998 B1**
(45) Veröffentlichungstag und Bekanntmachung des Hinweises auf die Patenterteilung: **07.06.2006**
(21) Anmeldenummer: 99105872.8
(22) Anmeldetag: 23.03.1999
(51) Int. Cl.: H04B 7/08, H04B 1/68

(54) **Empfänger für Hochfrequenzsignale mit zwei oder mehr Empfangspfaden**
Receiver for high frequency signals with two or more receiver branches
Récepteur de signaux à haute fréquence avec deux ou plus branches de réception

(30) Priorität: 26.03.1998 DE 19813501
(43) Veröffentlichungstag der Anmeldung: 29.09.1999
(73) Patentinhaber: SIEMENS AKTIENGESELLSCHAFT, 80333 München (DE)
(72) Erfinder: Splett, Armin, Dr., 89081 Ulm (DE); Helms, Jochen, Dr., 81673 München (DE)

(56) Entgegenhaltungen:
- EP-A- 0 823 790
- US-A- 4 313 220
- US-A- 4 947 453

## Beschreibung

Die Erfindung bezieht sich auf einen Empfänger für Hochfrequenzsignale mit zwei oder mehr Empfangspfaden, deren Ausgangssignale einem auswertenden Detektor zugeführt sind.

Beim Empfang eines Hochfrequenznutzsignals wird im allgemeinen die Trägerfrequenz auf eine Zwischenfrequenz gemischt bzw. bei hochwertigeren Empfängern erfolgt eine solche Mischung zumindest zweimal mit dementsprechend zwei Zwischenfrequenzstufen. Die Trägerfrequenz des Eingangssignals wird im allgemeinen in eine niedrigere Frequenzlage oder in das Basisband umgesetzt und dann einem Detektor zugeführt. Aufgrund der nicht idealen verwendeten Umsetzstufen, wie Mischer, Abtast- und Halteschaltungen, Komparatoren, Analog/Digital-Wandler, etc. oder auch aufgrund der verwendeten Empfängerstruktur werden auch nicht gewünschte Hochfrequenzsignale auf anderen Trägerfrequenzen in die gleiche niedrigere Frequenzlage wie das Hochfrequenznutzsignal umgesetzt, wobei sie das Nutzsignal im Detektor überlagern und so zu einer fehlerhaften Auswertung des Nutzsignals führen. Ein typisches Beispiel dafür sind die Spiegelfrequenzen, doch gibt es auch andere Störmechanismen, die durch geeignete Maßnahmen zu eliminieren oder zu verringern sind. Eine allgemeine Übersicht darüber findet sich beispielsweise in "Taschenbuch der Hochfrequenztechnik" Band 3: Systeme, Q:Empfänger, 1.3 Empfängereigenschaften; Meinke-Gundlach, Springer Verlag 1992. Die Problematik ist im Prinzip bei analogen Empfängerkonzepten die gleiche wie bei digitalen Empfängern. Zur Beseitigung bzw. Unterdrückung der genannten Störsignale verwendet man derzeit oft sehr aufwendige analoge Filter am Eingang des Empfängers bzw. vor jeder Umsetzungsstufe (Mischer), wobei allerdings bei Breitbandempfängern, z.B. mit Breitband-Analog/Digital-Wandlern eine analoge Filterung nur begrenzt oder überhaupt nicht möglich ist.

Aus EP 0 823 790 A2 ist eine Dual-Band Mobile Station bekannt, bei der ein über eine gemeinsame Antenne empfangenes RF-Signal mit zwei Frequenzbändern frequenzabhängig jeweils zugeordneten Receivern zugeführt wird.

Eine Aufgabe der Erfindung liegt darin, einen Empfänger zu schaffen, bei welchem auf wirkungsvolle und dennoch einfach zu realisierende Weise sehr gute Selektionseigenschaften im Sinne der Unterdrückung von unerwünschten Störmechanismen, wie Spiegelfrequenzen, etc. geschaffen werden.

Die gestellte Aufgabe wird mit einem Empfänger der eingangs genannten Art gelöst, bei welchem erfindungsgemäß zumindest zwei Empfangspfade unterschiedliches nichtlineares Übertragungsverhalten aufweisen.

Es ist zwar bekannt, bei Empfängern mehrere Empfangspfade auszuführen, z.B. für die Kompensation von Rayleigh-Fading beim Mobilfunk, doch hat man sich bemüht, die Empfangspfade möglichst gleich aufzubauen. Das erfindungsgemäße Konzept geht einen dazu konträren Weg und erreicht damit eine hervorragende Unterdrückung der genannten Störsignale, d.h. eine verbesserte Störfestigkeit bei Einsparung aufwendiger analoger Filter.

Bei einer vorteilhaften Ausführungsform eines Empfängers, bei welchem jeder Empfangspfad zumindest eine Mischstufe zur Umsetzung eines Eingangssignals in eine Zwischenfrequenzlage aufweist, sind zumindest zwei Empfangspfade mit unterschiedlichen Zwischenfrequenzen vorgesehen. In diesem Fall kann aber auch jeder Empfangspfad eine erste Mischstufe zum Mischen auf verschiedene erste Zwischenfrequenzen sowie eine zweite Mischstufe zum Mischen auf gleiche zweite Zwischenfrequenzen aufweisen, da durch Verwendung gleicher zweiter Zwischenfrequenzen die Verarbeitung in dem auswertenden Detektor einfacher sein kann.

Bei einem Empfänger, bei welchem die Empfangspfade Analog/Digital-Wandler enthalten, ist es im Sinne der Erfindung zweckmäßig, wenn die Analog/Digital-Wandler in zumindest zwei Empfangspfaden unterschiedliche Abtastfrequenzen aufweisen. Da die unerwünschten Mischprodukte, die in Analog/Digital-Wandlern als Harmonische der Abtastfrequenz und Harmonische eines unerwünschten Signals entstehen, für fast alle Eingangsfrequenzen des unerwünschten Signals mit unterschiedlichen Ausgangsfrequenzen an den Analog/Digital-Wandlern auftreten, ist die Überlagerung des Nutzsignals nur in maximal einem Pfad zu erwarten und über die anderen Pfade ist die Detektion möglich.

Andererseits kann bei einem Empfänger, dessen Empfangspfade Analog/Digital-Wandler enthalten, auch vorgesehen sein, daß die Analog/Digital-Wandler in zumindest zwei Empfangspfaden unterschiedliche Wandlerkennlinien aufweisen. Wenn beispielsweise ein Wandler von einer quadratischen Nichtlinearität und der andere Wandler von einer kubischen Nichtlinearität beherrscht wird, führen diese unterschiedlichen Nichtlinearitäten zu unterschiedlichen Störfrequenzen, die durch gemeinsame Detektion der beiden Ausgangssignale der Empfangspfade eliminierbar sind.

Bei einer zweckmäßigen Ausführungsform sind die Eingangssignale aller Pfade gleich, d. h. sie gelangen beispielsweise von einer einzigen Antenne in gleicher Weise zu jedem Empfangspfad.

Die Erfindung samt weiterer Vorteile ist im folgenden anhand beispielsweiser Ausführungsformen näher erläutert, die in der Zeichnung veranschaulicht sind. In dieser zeigen
Fig. 1 ein prinzipielles Blockschaltbild eine ersten Ausführungsform eines Empfängers nach der Erfindung,
Fig. 2 in einem ebensolchen Blockschaltbild eine zweite Ausführungsform eines Empfängers nach der Erfindung und
Fig. 3 wieder in einem Blockschaltbild eine dritte Ausführungsform eines Empfängers nach der Erfindung.

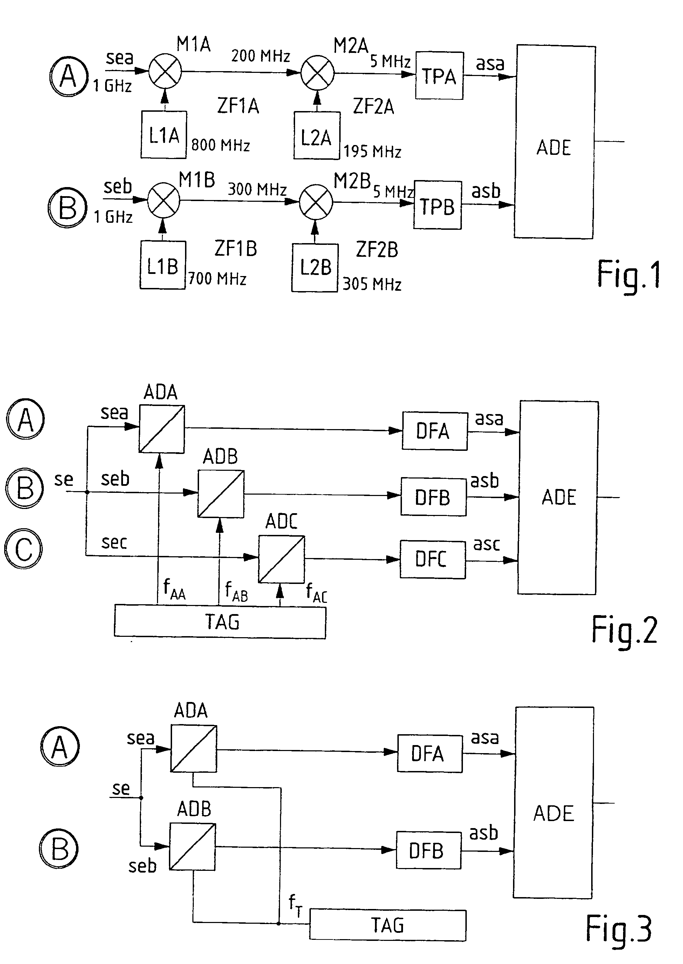

Bei dem Ausführungsbeispiel nach Fig. 1 liegt ein Empfänger mit zwei Empfangspfaden A und B vor, wobei diesen Pfaden je das gleiche Eingangssignal sea und seb zugeführt wird, z. B. ein Nutzsignalträger von 1 GHz. Dieses Eingangssignal wird in einem Mischer M1A bzw. in einem Mischer M1B zunächst durch Lokaloszillatoren L1A mit 800 MHz und L1B mit 700 MHz auf eine erste Zwischenfrequenz von 200 MHz in Pfad A bzw. auf eine erste Zwischenfrequenz von 300 MHz in Pfad B umgesetzt. Diese unterschiedlichen Zwischenfrequenzen werden sodann je in einer zweiten Mischstufe M2A bzw. M2B mit Hilfe eines Lokaloszillators L2A bzw. L2B auf eine gleiche zweite Zwischenfrequenz von 5 MHz umgesetzt, nämlich mit Hilfe eines Lokaloszillators L2A, der auf 195 MHz arbeitet bzw. eines Lokaloszillators L2B für den zweiten Pfad, der auf 305 MHz arbeitet. Es wird somit an den beiden ersten Mischern M1A und M1B sowie an dem zweiten Mischer des Pfades A, dem Mischer M2A, in Gleichlage gemischt, am zweiten Mischer M2B des Pfades B jedoch in Kehrlage.

Auf die zweiten Mischer M2A und M2B folgt je ein Tiefpaß TPA bzw. TPB, der bei diesem Ausführungsbeispiel eine Grenzfrequenz von ca. 10 MHz aufweist, mit geringem Aufwand hergestellt werden kann und der unerwünschte Signale dämpft. Die Ausgangssignale asa und asb der beiden Pfade A und B werden letztlich einem auswertenden Detektor ADE zugeführt, welcher die unterschiedlichen Lagen der Signale bei der gemeinsamen Detektion berücksichtigt.

Da die Empfangspfade bzw. die Mischer keine bzw. eine nur unzureichende Spiegelfrequenzunterdrückung aufweisen, führen unerwünschte Hochfrequenzsignale als Spiegelfrequenzen zur Überlagerung des Nutzsignals, jedoch immer nur in einem Empfangspfad, was in der nachstehenden Tabelle verdeutlicht ist.

**Tabelle**

| **sea=seb** | **ZF1A** | **ZF1B** | **ZF2A** | **ZF2B** | **gestörter Pfad** |
|---|---|---|---|---|---|
| 1000 | 200 | 300 | 5 | 5 | Nutzsignal |
| 390 | 410 | 310 | 215 | 5 | B |
| 400 | 400 | 300 | 205 | 5 | B |
| 600 | 200 | 100 | 5 | 205 | A |
| 610 | 190 | 90 | 5 | 215 | A |
| 990 | 190 | 290 | 5 | 15 | A |
| 1010 | 210 | 310 | 15 | 5 | B |

In der Tabelle sind die Frequenzen der verschiedenen Signale gemäß Fig.1 in MHz angegeben. Das erwünschte Eingangssignal von 1000 MHz führt zu dem Nutzsignal am Ausgang, wogegen die restlichen sechs angegebenen Frequenzen des Eingangssignals nur je in einem Pfad zu einer Störung führen.

Die Ausführung nach Fig. 2 verwendet drei Pfade A, B, und C und in jedem der Pfade ist ein Analog/Digital-Wandler ADA, ADB und ADC vorgesehen, wobei diese Analog/Digital-Wandler mit Abtastfrequenzen f_{AA}, f_{AB} und f_{AC} arbeiten, die von einem Taktgenerator TAG stammen. Die Eingangssignale der einzelnen Pfade A, B und C sind hier mit sea, seb und sec bezeichnet und seien auch in diesem Fall alle gleich, d. h. auf ein gemeinsames Eingangssignal se zurückführbar.

Die Abtastfrequenzen f_{AA}, f_{AB} und f_{AC} sind unterschiedlich, sodaß die unerwünschten Mischprodukte, die in den Analog/Digital-Wandlern aus Harmonischen der Abtastfrequenz und Harmonischen eines unerwünschten Signals entstehen, für fast alle Eingangsfrequenzen des unerwünschten Signals mit unterschiedlichen Ausgangsfrequenzen an den Analog/Digital-Wandlern auftreten. Die Überlagerung des Nutzsignals ist daher nur in maximal einem der Pfade A, B und C zu erwarten, wogegen über die anderen Pfade die Detektion in dem nachgeschalteten Detektor ADE möglich ist. Diesem werden die Ausgangssignale asa, asb, asc von digitalen Filtern DFA, DFB und DFC zugeführt, die je zwischen die Analog/Digital-Wandler ADA, ADB und ADC und den auswertenden Detektor ADE geschaltet sind. Es ist für den Fachmann verständlich, daß die Dynamik des Empfängers, d.h. der Abstand zwischen maximalem Signalpegel und Rauschpegel mit der Anzahl der verwendeten Pfade wachst.

Das dritte Ausführungsbeispiel nach Fig. 3 verwendet in zwei Empfangspfaden A und B je einen Analog/Digital-Wandler ADA und ADB, wobei jeder der Analog/Digital-Wandler mit der gleichen Frequenz f_{T} von einem Taktgenerator TAG bezüglich seiner Abtastung gesteuert ist.

Im Sinne der Erfindung sind jedoch die Analog/Digital-Wandler ADA und ADB insofern unterschiedlich ausgeführt, als sie verschiedene Wandlerkennlinien aufweisen. Jeder Analog/Digital-Wandler besitzt eine Kennlinie, welche die Abhängigkeit seines Ausgangswertes x von seiner Eingangsspannung u angibt. Beispielsweise wird bei Vorherrschen einer quadratischen Nichtlinearität der Ausgangswert durch die Gleichung x = a₁·u + a₂·u² darstellbar sein, hingegen bei Vorherrschen einer kubischen Nichtlinearität durch die Gleichung x = a₁·u + a₃·u³.

Bei der Ausführung nach Fig. 3 kann nun beispielsweise der Wandler ADA mit einer quadratischen Wandlerkennlinie ausgestattet sein, wogegen der Wandler ADB des Pfades B eine kubische Nichtlinearität besitzt. Bei einem Nutzsignal von f = 100 MHz und einer Abtastfrequenz von f_{D} = 80 MHz ergibt sich eine Ausgangsfrequenz der Analog/Digital-Wandler ADA und ADB von f_{IF} = f_{N} - f_{T} = 20 MHz. Für die Störfrequenzen f_{ST} muß die Gleichung gelten: m·f_{ST} + n·f_{T} = f_{IF}, wobei hier für den ersten Analog/Digital-Wandler ADA gilt: | m | ∈{1;2} und für den zweiten Analog/Digital-Wandler ADB des Pfades B | m | ∈{1;3}.

Für m = 2 und n = -1 ergibt sich beispielsweise eine Störfrequenz von f_{ST} = 50 MHz und für m = 3 und n = -1 eine Störfrequenz von f_{ST} = 33,3 MHz usf. Im Ergebnis führt daher die Ausführungsform nach Fig.3 wiederum dazu, daß Störungen im allgemeinen lediglich in einem Pfad auftreten und der auswertende Detektor ADE, dem auch hier digitale Filter DFA und DFB vorgeschaltet sind, seine Aufgabe dahingehend erfüllen kann, daß er die Störsignale von dem Nutzsignal trennt.

Es ist schließlich zu bemerken, daß hier drei verschiedene Ausführungsformen beschrieben wurden, die bei Bedarf jedoch auch miteinander kombiniert werden können, um die Störfestigkeit noch weiter zu erhöhen. In Zusammenhang mit der Ausführung nach Fig. 3 sei auch angemerkt, daß bereits die Verwendung unterschiedlicher Fabrikate von Analog/Digital-Wandlern die Anwendung unterschiedlicher Wandlerkennlinien nach sich zieht und daher gezielt im Sinne der Erfindung eingesetzt werden kann.

## Patentansprüche

1. Empfänger für Hochfrequenzsignale mit zwei oder mehr Empfangspfaden (A, B, C), denen das gleiche Eingangssignal (sea, seb, sec) zugeführt wird, und deren Ausgangssignale (asa, asb, asc) einem auswertenden Detektor (ADE) zur gemeinsamen Detektion zugeführt sind,
**dadurch gekennzeichnet,**
- **dass** zur Erhöhung der Störfestigkeit zumindest zwei Empfangspfade (A, B, C) ein vorbestimmtes, unterschiedliches, nichtlineares Übertragungsverhalten aufweisen,
- wobei das Übertragungsverhalten dadurch gebildet wird, dass in jedem Empfangspfad (A, B) in einem ersten Schritt eine Umsetzung des Eingangssignals (sea, seb) in eine erste Zwischenfrequenz (ZF1A, ZF1B), die für jeden Empfangspfad (A, B) unterschiedlich gewählt wird, erfolgt und in einem zweiten Schritt das umgesetzte Eingangssignal in eine für alle Empfangspfade (A, B) gleiche Zwischenfrequenz umgesetzt wird.

2. Empfänger nach Anspruch 1, **dadurch gekennzeichnet,**
- **dass** ein erster Empfangspfad (A) eine erste Mischstufe (M1A) zur Umsetzung des Eingangssignals (sea, seb) in eine Zwischenfrequenz (ZF1A) aufweist,
- **dass** ein zweiter Empfangspfad (B) eine erste Mischstufe (M1B) zur Umsetzung des Eingangssignals (sea, seb) in eine zwischenfrequenz (ZF1B) aufweist, und
- **dass** die Zwischenfrequenz (ZF1A) des ersten Empfangspfads (A) und die Zwischenfrequenz (ZF1B) des zweiten Empfangspfads (B) unterschiedlich gewählt sind.

3. Empfänger nach Anspruch 1, **dadurch gekennzeichnet,**
- **dass** der erste Empfangspfad (A) eine zweite Mischstufe (M2A) aufweist, mit der das auf die Zwischenfrequenz (ZF1A) des ersten Empfangspfads (A) umgesetzte Eingangssignal (sea, seb) in eine zweite Zwischenfrequenz (ZF2A, ZF2B) umgesetzt wird, und
- **dass** der zweite Empfangspfad (B) eine zweite Mischstufe (M2B) aufweist, mit der das auf die Zwischenfrequenz (ZF1B) des zweiten Empfangspfads (B) umgesetzte Eingangssignal (sea, seb) in die gleiche zweite Zwischenfrequenz (ZF2A, ZF2B) umgesetzt wird.

4. Empfänger für Hochfrequenzsignale mit zwei oder mehr Empfangspfaden (A, B, C), denen das gleiche Eingangssignal (sea, seb, sec) zugeführt wird, und deren Ausgangssignale (asa, asb, asc) einem auswertenden Detektor (ADE) zur gemeinsamen Detektion zugeführt sind,
**dadurch gekennzeichnet,**
- **dass** zur Erhöhung der Störfestigkeit zumindest zwei Empfangspfade (A, B, C) ein vorbestimmtes, unterschiedliches, nichtlineares Übertragungsverhalten aufweisen,
- wobei das Übertragungsverhalten dadurch gebildet wird, dass in jedem Empfangspfad (A, B, C) eine Analog/Digital-Wandlung mit Abtastung des Eingangssignals (sea, seb, sec) erfolgt und für jeden Empfangspfad (A, B, C) unterschiedliche Abtastfrequenzen (f_{AA}, f_{AB}, f_{AC}) verwendet werden.

5. Empfänger nach Anspruch 4, **dadurch gekennzeichnet,**
- **dass** jeder Empfangspfad (A, B, C) einen Analog/Digital-Wandler (ADA, ADB, ADC) beinhaltet, an den das Eingangssignal zur A/D-Wandlung und Abtastung gelangt, und
- **dass** die Analog/Digital-Wandler (ADA, ADB, ADC) von zumindest zwei Empfangspfaden (A, B, C) unterschiedliche Abtastfrequenzen (f_{AA}, f_{AB}, f_{AC}) aufweisen.

6. Empfänger für Hochfrequenzsignale mit zwei oder mehr Empfangspfaden (A, B, C), denen das gleiche Eingangssignal (sea, seb, sec) zugeführt wird, und deren Ausgangssignale (asa, asb, asc) einem auswertenden Detektor (ADE) zur gemeinsamen Detektion zugeführt sind,
**dadurch gekennzeichnet,**
- **dass** zur Erhöhung der Störfestigkeit zumindest zwei Empfangspfade (A, B, C) ein vorbestimmtes, unterschiedliches, nichtlineares Übertragungsverhalten aufweisen,
- wobei das Übertragungsverhalten dadurch gebildet wird, dass in jedem Empfangspfad (A, B, C) eine Analog/Digital-Wandlung des Eingangssignals erfolgt und wobei die Analog/Digital-Wandlung mit unterschiedlichen Wandlerkennlinien bei jedem Empfangspfad (A, B, C) durchgeführt wird.

7. Empfänger nach Anspruch 6, **dadurch gekennzeichnet,**
- **dass** jeder Empfangspfad (A,B) einen Analog/Digital-Wandler (ADA, ADB) beinhaltet, und
- **dass** die Analog/Digital-Wandler (ADA, ADB) von zumindest zwei Empfangspfaden (A, B) unterschiedliche Wandlerkennlinien aufweisen.

## Claims

1. Receiver for high-frequency signals with two or more receive paths (A, B, C), to which the same input signal (sea, seb, sec) is supplied, and the output signals (asa, asb, asc) of which are supplied to an evaluating detector (ADE) for common detection,
**characterised in that**
- to increase interference resistance at least two receive paths (A, B, C) have a predefined, different, non-linear transmission response,
- with the transmission response being determined by the fact that in every receive path (A, B) in a first step the input signal (sea, seb) is converted to a first intermediate frequency (ZF1A, ZF1B), which is different for each receive path (A, B) and in a second step the converted input signal is converted to an intermediate frequency that is the same for all receive paths (A, B).

2. Receiver according to claim 1, **characterised in that**
- a first receive path (A) has a first mixing stage (M1A) for converting the input signal (sea, seb) to an intermediate frequency (ZF1A),
- a second receive path (B) has a first mixing stage (M1B) for converting the input signal (sea, seb) to an intermediate frequency (ZF1B) and
- the intermediate frequency (ZF1A) of the first receive path (A) and the intermediate frequency (ZF1B) of the second receive path (B) are different.

3. Receiver according to claim 1, **characterised in that**
- the first receive path (A) has a second mixing stage (M2A), with which the input signal (sea, seb) converted to the intermediate frequency (ZF1A) of the first receive path (A) is converted to a second intermediate frequency (ZF2A, ZF2B) and
- the second receive path (B) has a second mixing stage (M2B), with which the input signal (sea, seb) converted to the intermediate frequency (ZF1B) of the second receive path (B) is converted to the same second intermediate frequency (ZF2A, ZF2B).

4. Receiver for high-frequency signals with two or more receive paths (A, B, C), to which the same input signal (sea, seb, sec) is supplied, and the output signals (asa, asb, asc) of which are supplied to an evaluating detector (ADE) for common detection,
**characterised in that**
- to increase interference resistance at least two receive paths (A, B, C) have a predefined, different, non-linear transmission response,
- with the transmission response being determined by the fact that in every receive path (A, B, C) analogue/digital conversion takes place with scanning of the input signal (sea, seb, sec) and different scanning frequencies (f_{AA}, f_{AB}, f_{AC}) are used for each receive path (A, B, C).

5. Receiver according to claim 4, **characterised in that**
- each receive path (A, B, C) contains an analogue/digital converter (ADA, ADB, ADC), to which the input signal passes for A/D conversion and scanning and
- the analogue/digital converters (ADA, ADB, ADC) of at least two receive paths (A, B, C) have different scanning frequencies (f_{AA}, f_{AB}, f_{AC}).

6. Receiver for high-frequency signals with two or more receive paths (A, B, C), to which the same input signal (sea, seb, sec) is supplied, and the output signals (asa, asb, asc) of which are supplied to an evaluating detector (ADE) for common detection,
**characterised in that**
- to increase interference resistance at least two receive paths (A, B, C) have a predefined, different, non-linear transmission response,
- with the transmission response being determined by the fact that in every receive path (A, B, C) analogue/digital conversion of the input signal takes place and with analogue/digital conversion being carried out with different converter characteristics for each receive path (A, B, C).

7. Receiver according to claim 6, **characterised in that**
- each receive path (A, B) contains an analogue/digital converter (ADA, ADB) and
- the analogue/digital converters (ADA, ADB) of at least two receive paths (A, B) have different converter characteristics.

## Revendications

1. Récepteur pour des signaux à haute fréquence comprenant deux chemins de réception ou plus (A, B, C), auxquels est amené le même signal d'entrée (sea, seb, sec), et dont les signaux de sortie (asa, asb, asc) sont amenés à un détecteur d'analyse (ADE) pour la détection commune,
**caractérisé en ce que**,
- pour l'amélioration de la résistance au brouillage, au moins deux chemins de réception (A, B, C) présentent un comportement à la transmission prédéfini, différent et non linéaire,
- le comportement à la transmission étant formé par le fait que, dans chaque chemin de réception (A, B), on a dans une première étape une conversion du signal d'entrée (sea, seb) en une première fréquence intermédiaire (ZF1A, ZF1B), qui est choisie différente pour chaque chemin de réception (A, B) et dans une seconde étape le signal d'entrée converti est converti dans une fréquence intermédiaire identique pour tous les chemins de réception (A, B).

2. Récepteur selon la revendication 1, **caractérisé en ce que**,
- un premier chemin de réception (A) présente un premier niveau de mélange (M1A) pour la conversion du signal d'entrée (sea, seb) en une fréquence intermédiaire (ZF1A),
- **en ce qu'**un second chemin de réception (B) présente un premier niveau de mélange (M1B) pour la conversion du signal d'entrée (sea, seb) en une fréquence intermédiaire (ZF1B), et
- **en ce que** la fréquence intermédiaire (ZF1A) du premier chemin de réception (A) et la fréquence intermédiaire (ZF1B) du second chemin de réception (B) sont choisies différentes.

3. Récepteur selon la revendication 1, **caractérisé en ce que**,
- le premier chemin de réception (A) présente un second niveau de mélange (M2A), avec lequel le signal d'entrée (sea, seb) converti à la fréquence intermédiaire (ZF1A) du premier chemin de réception (A) est converti en une seconde fréquence intermédiaire (ZF2A, ZF2B), et
- **en ce que** le second chemin de réception (B) présente un second niveau de mélange (M2B), avec lequel le signal d'entrée (sea, seb) converti à la fréquence intermédiaire (ZF1B) du second chemin de réception (B) est converti dans la seconde fréquence intermédiaire (ZF2A, ZF2B) identique.

4. Récepteur pour des signaux à haute fréquence comprenant deux chemins de réception (A, B, C) ou plus, auxquels le même signal d'entrée (sea, seb, sec) est amené, et dont les signaux d'entrée (asa, asb, asc) sont amenés à un détecteur d'analyse (ADE) pour la détection commune,
**caractérisé en ce que**,
- pour l'amélioration de la résistance au brouillage, au moins deux chemins de réception (A, B, C) présentent un comportement à la transmission prédéfini, différent et non linéaire,
- le comportement à la transmission étant formé par le fait que, dans chaque chemin de réception (A, B, C), on a une conversion analogique/numérique avec un balayage du signal d'entrée (sea, seb, sec) et on utilise pour chaque chemin de réception (A, B, C) différentes fréquences de balayage (f_{AA}, f_{AB}, f_{AC}).

5. Récepteur selon la revendication 4, **caractérisé en ce que**,
- chaque chemin de réception (A, B, C) contient un convertisseur analogique/numérique (ADA, ADB, ADC), sur lequel arrive le signal d'entrée pour la conversion analogique/numérique et le balayage, et
- **en ce que** les convertisseurs analogique/numérique (ADA, ADB, ADC) d'au moins deux chemins de réception (A, B, C) présentent différentes fréquences de balayage (f_{AA}, f_{AB}, f_{AC}).

6. Récepteur pour des signaux à haute fréquence comprenant deux chemins de réception (A, B, C) ou plus, auxquels le même signal d'entrée (sea, seb, sec) est amené, et dont les signaux d'entrée (asa, asb, asc) sont amenés à un détecteur d'analyse (ADE) pour la détection commune,
**caractérisé en ce que**,
- pour l'amélioration de la résistance au brouillage, au moins deux chemins de réception (A, B, C) présentent un comportement à la transmission prédéfini, différent et non linéaire,
- le comportement à la transmission étant formé par le fait que, dans chaque chemin de réception (A, B, C), on a une conversion analogique/numérique du signal d'entrée et la conversion analogique/numérique étant effectuée avec différentes courbes caractéristiques de convertisseur dans chaque chemin de réception (A, B, C).

7. Récepteur selon la revendication 6, **caractérisé en ce que**
- chaque chemin de réception (A, B) contient un convertisseur analogique/numérique (ADA, ADB), et
- **en ce que** les convertisseurs analogique/numérique (ADA, ADB) d'au moins deux chemins de réception (A, B) présentent différentes courbes caractéristiques de convertisseur.
